# EUROPEAN PATENT APPLICATION

(11) **EP 2 706 576 A2**
(43) Date of publication of application: **12.03.2014**
(21) Application number: 13181392.5
(22) Date of filing: 22.08.2013
(51) Int. Cl.: H01L 29/861, H01L 29/872

(54) **Diode and power conversion system**

(30) Priority: 07.09.2012 JP 2012196885
(71) Applicant: Hitachi Ltd., Tokyo (JP)
(72) Inventor: Ishimaru, Tetsuya, Tokyo, 100-8280 (JP); Mori, Mutsuhiro, Tokyo, 100-8280 (JP)
(74) Representative: Beetz & Partner

(57) **Abstract**

A diode includes: a first semiconductor layer (101) of a first conductive type; a second semiconductor layer (102) of a second conductive type arranged adjoining to the first semiconductor layer (101); a third semiconductor layer (104) of the first conductive type which is arranged on a side, opposite to the second semiconductor layer (12), of the first semiconductor layer (101), and contains a dopant of the first conductive type at a higher concentration than the first semiconductor layer (101); a first electrode (107) ohmically connected to the second semiconductor layer (102); a second electrode (108) ohmically connected to the third semiconductor layer (104); and a fourth semiconductor layer (106) which is arranged at a position adjoining to the third semiconductor layer (104) between the first and third semiconductor layers (101, 104), contains a dopant of a type which is the same as a type of the dopant of the first conductive type contained in the third semiconductor layer (104), and has a carrier lifetime shorter than the third semiconductor layer (104).

## Description

### BACKGROUND OF THE INVENTION

### Field of the Invention

The present invention relates to a diode and a power conversion system using the diode.

### Description of the Related Art

Recently, the switching frequency in the power conversion system has been demanded to be increased. In the power conversion system, a diode is connected in reverse parallel with an IGBT (insulated gate bipolar transistor) or an MOS (metal oxide semiconductor) transistor for use as a free wheeling diode. With the increase in the switching frequency in the power conversion system, reduction in recovery loss in the above diode which occurs at the time of switching has been increasingly demanded.

The recovery loss increases with the magnitude of the tail current which flows through the diode at the time of recovery. Therefore, in order to reduce the recovery loss, techniques for reducing the magnitude of the tail current have been proposed.

For example, a rectifier diode having a cross-sectional structure as illustrated in FIG. 31 in Japanese Patent Laid-Open No. 10-74959 (hereinafter referred to as JP10-74959A) has been proposed. In the rectifier diode illustrated in FIG. 31 in JP10-74959A, in order to suppress the carrier density in the n-type cathode layer 281, which is located on the cathode electrode 290 side and is a source of the tail current, a low-carrier-lifetime region 291 is formed in the n-type cathode layer 281 in advance by irradiation with a beam of particles such as protons, He⁺ ions, or the like.

In addition, JP10-74959A also discloses a rectifier diode illustrated in FIG. 1 in JP10-74959A, which has the following structure. This rectifier diode is formed by selectively forming a low-resistance p-type anode 2 by diffusion on a surface of a high-resistance n-type cathode layer 1, and forming a low-resistance n-type cathode layer 3 on a back surface of the n-type cathode layer 1, so that the above rectifier diode is configured with the n-type cathode layer 1, the p-type anode 2, and the n-type cathode layer 3. Further, in the above rectifier, in order to reduce the tail current, a low-carrier-lifetime region 8 is formed in the n-type cathode layer 3 by irradiation with a beam of particles such as protons.

However, in the rectifier diode illustrated in FIG. 31 in JP10-74959A, a process of particle beam irradiation is needed for forming the low-carrier-lifetime region 291 in the n-type cathode layer 281, and use of a large particle-beam irradiation system using a cyclotron is needed for irradiation with protons or helium ions. In addition, since the low-carrier-lifetime region 291 is formed in the n-type cathode layer 281, when reverse voltage is applied to the rectifier diode and a depletion layer extends from the PN junction to the low-carrier-lifetime region 291 in the n-type cathode layer 281, the leakage current increases because of the defects existing in the low-carrier-lifetime region 291. When the amount of the defects existing in the low-carrier-lifetime region 291 increases, the breakdown voltage is lowered.

Further, in the case where the low-carrier-lifetime region 291 is formed by irradiation with protons or helium ions, the width of the low-carrier-lifetime region 291 in the depth direction becomes as large as approximately 10 to 70 micrometers because of the light mass of the injected particles with which the n-type cathode layer 281 is irradiated, although the width varies with the irradiation energy. Therefore, the low-carrier-lifetime region 291 becomes closer to the anode electrode. Thus, even when a low reverse voltage is applied to the rectifier diode, the leakage current increases because of the low-carrier-lifetime region 291. When a high reverse voltage is applied to the rectifier diode, the leakage current due to the low-carrier-lifetime region 291 further increases.

Further, in the rectifier diode illustrated in FIG. 1 in JP10-74959A, a process of particle beam irradiation is also needed for forming the low-carrier-lifetime region 8, and use of a large particle-beam irradiation system using a cyclotron is needed for irradiation with protons or helium ions. In addition, in order to reduce the tail current at the time of recovery, it is necessary to quickly annihilate electrons and holes remaining on the cathode electrode side in the n-type cathode layer 1 at the time of recovery. However, in the case where the low-carrier-lifetime region 8 exists in the n-type cathode layer 3, it is impossible to efficiently annihilate the electrons and holes remaining on the cathode electrode side in the n-type cathode layer 1 at the time of recovery. Therefore, the effect of reducing the tail current and the recovery loss by only the provision of the low-carrier-lifetime region 8 in the n-type cathode layer 3 is small. Furthermore, in order to form the low-carrier-lifetime region 8 in the n-type cathode layer 1, it is necessary that the n-type cathode layer 3 have a thickness greater than the low-carrier-lifetime region 8 to be formed.

Moreover, in the case where the diode uses a substrate of a thin FZ (Floating Zone) wafer, the n-type cathode layer 3 is formed by grinding the back surface of the wafer to reduce the thickness of the wafer, implanting ions of an n-type dopant into the wafer, and thereafter activating the dopant by laser annealing. Therefore, the thickness of the n-type cathode layer 3 is as small as approximately 1 micrometer. It is difficult to form the low-carrier-lifetime region 8 in such a thin n-type cathode layer 3 by irradiation with particles such as protons or helium ions.

### SUMMARY OF THE INVENTION

An aspect of the present invention provides a diode which can be manufactured by a simple process enabling reduction of recovery loss without lowering of breakdown voltage.

An aspect of the invention provides a diode comprising:
a first semiconductor layer of a first conductive type;
a second semiconductor layer of a second conductive type which is arranged adjoining to the first semiconductor layer;
a third semiconductor layer of the first conductive type which is arranged on a side, opposite to the second semiconductor layer, of the first semiconductor layer, and contains a dopant of the first conductive type at a concentration higher than the first semiconductor layer;
a first electrode ohmically connected to the second semiconductor layer;
a second electrode ohmically connected to the third semiconductor layer; and
a fourth semiconductor layer which is arranged at a position adjoining to the third semiconductor layer between the first semiconductor layer and the third semiconductor layer, contains a dopant of which type is the same as a type of the dopant of the first conductive type contained in the third semiconductor layer, and has a carrier lifetime shorter than the third semiconductor layer.

An aspect of the present invention provides a power conversion system comprising:
a first switching element and a second switching element which are connected in series; and
a diode which is connected to each of the first switching element and the second switching element in a reverse parallel connection;
wherein the diode connected to each of the first switching element and the second switching element is the diode.

According to the present invention, it is possible to provide a diode which can be manufactured by a simple process enabling reduction of recovery loss without lowering of breakdown voltage, and not necessitating additional steps.

The other objects, structures, and advantages of the present invention will be clarified by the following explanations on embodiments of the present invention.

### BRIEF DESCRIPTION OF THE DRAWINGS

FIG. 1 is a schematic cross-sectional view of a diode according to a first embodiment of the present invention;
FIG. 2 is a schematic cross-sectional view illustrating a stage in a process for manufacturing the diode according to the first embodiment of the present invention;
FIG. 3 is a schematic cross-sectional view illustrating a stage in the process for manufacturing the diode according to the first embodiment of the present invention;
FIG. 4 is a schematic cross-sectional view illustrating a stage in the process for manufacturing the diode according to the first embodiment of the present invention;
FIG. 5 is a schematic cross-sectional view illustrating a stage in the process for manufacturing the diode according to the first embodiment of the present invention;
FIG. 6 is a graph indicating results of SIMS (secondary ion mass spectroscopy) and measurement of SR (spreading resistance), where the SIMS and the SR measurement are performed from a surface, on the cathode side, of a Si substrate of a diode as a concrete example of the present invention;
FIG. 7 is a schematic cross-sectional view of a diode according to a second embodiment of the present invention;
FIG. 8 is a schematic cross-sectional view of a diode according to a third embodiment of the present invention;
FIG. 9 is a diagram illustrating a configuration of a power conversion system according to a fourth embodiment of the present invention;
FIG. 10 is a graph indicating results of SIMS (secondary ion mass spectroscopy) and measurement of SR (spreading resistance), where the SIMS and the SR measurement are performed from a surface, on the cathode side, of a Si substrate of a diode as a comparison example 1;
FIG. 11 is a graph indicating results of measurement of the reverse characteristics of the diodes as the concrete example of the present invention and the comparison example 1;
FIG. 12 is a graph indicating results of measurement of waveforms of voltage and current at the time of recovery in the diodes as the concrete example of the present invention and the comparison example 1;
FIG. 13 is a graph indicating a result of measurement of a relationship between the forward voltage and the recovery loss in each of the diodes as the concrete example of the present invention and the comparison example 1;
FIG. 14 is a graph indicating a result of measurement of a relationship between the recovery loss and the activation ratio of the n-type dopant in a low-lifetime layer in the diode as the concrete example of the present invention; and
FIG. 15 is a graph indicating results of measurement of the reverse characteristics of the diodes as the concrete example of the present invention and a comparison example 2.

### DETAILED DESCRIPTION OF THE INVENTION

Hereinbelow, embodiments and concrete examples of the present invention are explained below with reference to accompanying drawings. In addition, in the following explanations, components or constituents having identical functions are indicated by the same reference numbers, and identical explanations are not repeated unless necessary.

In the following explanations on the embodiments, it is assumed that the first conductive type is n-type, the second conductive type is p-type, and the diodes according to the embodiments use an n-type Si substrate. However, the present invention is not limited to the above assumption. For example, even in the case where the first conductive type is p-type, and the second conductive type is n-type, and a p-type Si substrate is used, such diodes can be similarly handled.

### <First Embodiment>

### [Structure of Diode]

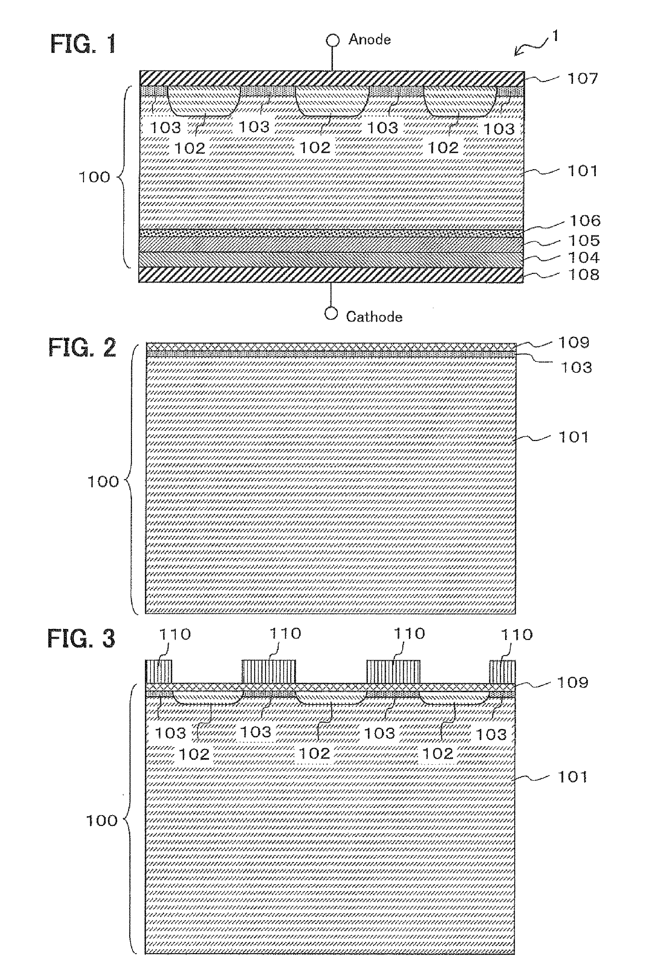

The structure of the diode according to the first embodiment of the present invention is explained below with reference to FIG. 1, which is a schematic cross-sectional view of the active region of the diode according to the first embodiment of the present invention. Although not shown, a conventional termination structure such as an FLR (field limiting ring) structure is used in the termination region. In the FLR structure, a p-type well and an electrode are arranged in a circular arrangement.

As illustrated in FIG. 1, the diode 1 according to the first embodiment is includes an n⁻ drift layer 101, an anode p layer 102, an anode p⁻ layer 103, a cathode n layer 104, a cathode buffer n layer 105, a low-lifetime region layer 106, an anode electrode 107, and a cathode electrode 108.

In the following explanations, the entire semiconductor layered portion in each stage in the process for manufacturing the diode may be referred to as the Si substrate 100.

The n⁻ drift layer 101 (the first semiconductor layer) is a semiconductor layer of n-type Si, which remains unchanged from the original state of the n-type Si substrate, i.e., is not altered by implantation, diffusion, or the like of ions.

The cathode n layer 104 (the third semiconductor layer) is an n-type semiconductor layer which is an n-type doped region having a higher dopant concentration than the n⁻ drift layer 101, and arranged on the back side of the Si substrate 100 (i.e., on the cathode side).

The cathode buffer n layer 105 (the fifth semiconductor layer in the third semiconductor layer) is an n-type semiconductor layer having an n-type doped region having a dopant concentration lower than the cathode n layer 104 and higher than the n⁻ drift layer 101, and arranged adjoining to the cathode n layer 104 on the n⁻ drift layer 101 side of the cathode n layer 104. The cathode buffer n layer 105 can be dispensed with. However, in the case where the cathode buffer n layer 105 is arranged, extension of the depletion layer from the PN junction toward the cathode side when reverse voltage is applied to the diode 1 can be suppressed, so that the breakdown voltage can be raised.

The low-lifetime region layer 106 (the fourth semiconductor layer) is an n-type semiconductor layer having a carrier lifetime smaller than the cathode buffer n layer 105, and arranged between the cathode buffer n layer 105 and the n⁻ drift layer 101. The low-lifetime region layer 106 is located adjoining to the cathode buffer n layer 105, and contains the same type of dopant (element) as the n-type dopant contained in the cathode buffer n layer 105.

Details of the structure of the above n-type semiconductor layers will be explained later in the section of "Conditions for Ion Implantation and Laser Annealing."

The anode p layer 102 (the second semiconductor layer) is a p-type semiconductor layer which is a p-type doped region, and locally formed on the anode side (surface side) of the Si substrate 100.

The anode p⁻ layer 103 is a p-type semiconductor layer which is a p-type doped region having a dopant concentration lower than the anode p layer 102, and formed in the regions on the anode side (surface side) of the Si substrate 100 in which the anode p layer 102 is not formed.

That is, the above p-type semiconductor layers form a well structure in which the anode p⁻ layer 103 (which is a thin, low-concentration p-type doped region layer) is formed on the surface side of the Si substrate 100, and the anode p layer 102 (which is constituted by a thick, high-concentration p-type doped region) is locally formed.

The active region in the diode according to the present embodiment contains the well structure in which the anode p layer 102 is locally arranged, and is configured to suppress the amount of holes implanted from the anode electrode 107 for softening the recovery (i.e., for suppressing voltage leap or ringing at the time of recovery).

The anode p layer 102 which is locally arranged as illustrated in FIG. 1 may be formed to have a dot-like or stripe-like shape in plan view from the surface side of the Si substrate 100 (i.e., from the anode side). For example, the anode p layer 102 may be formed in circular shapes having the diameter of 10 micrometers and being spaced 10 micrometers apart. In addition, the depth of the anode p layer 102 may be approximately 3 to 10 micrometers, and the peak concentration of the p-type dopant in the anode p layer 102 may be approximately 1 X 10¹⁷ to 1 X 10¹⁹ cm⁻³. The dopant concentration and dimensions of the anode p layer 102 are appropriately set according to the breakdown voltage and the specification requirements of the diode.

In the surface side of the Si substrate 100, the anode p⁻ layer 103 is formed in the regions other than the regions in which the anode p layer 102 is formed, where the concentration of the p-type dopant in the anode p⁻ layer 103 is lower than the concentration of the p-type dopant in the anode p layer 102. It is preferable that the peak concentration of the p-type dopant in the anode p⁻ layer 103 be approximately 1 X 10¹⁵ to 1 X 10¹⁷ cm⁻³.

In the case where the anode p⁻ layer 103 is arranged, the leakage current flowing out of the anode electrode 107 can be reduced, compared with the case where the anode p⁻ layer 103 is not arranged. However, in the case where the leakage current is allowed to flow out of the anode electrode 107, it is possible to omit the anode p⁻ layer 103 and arrange only the anode p layer 102 (which is locally arranged as a p-type semiconductor layer). In this case, the process for manufacturing the diode can be simplified by omission of a step of implanting the p-type dopant ions for forming the anode p⁻ layer 103.

The anode electrode 107 (the first electrode) is an electrode ohmically connected to the anode p layer 102, and the cathode electrode 108 (the second electrode) is an electrode ohmically connected to the cathode n layer 104.

### [Process for Manufacturing Diode]

Hereinbelow, an example of a process for manufacturing the active region of the diode 1 according to the first embodiment is explained with reference to FIGS. 2 to 5 (and FIG. 1 when necessary). Although the termination region of the diode 1 is produced concurrently with the active region, the process for manufacturing the termination region is simply explained since the process for manufacturing the termination region is identical to the process for manufacturing the termination region of the conventional diode.

### (Preparation of Substrate)

First, a Si wafer is prepared as the Si substrate 100 for production of the diode 1. An FZ (Floating Zone) wafer having a resistivity corresponding to the breakdown voltage can be used as the Si wafer. In the present embodiment, the bulk of the FZ wafer is used as the n⁻ drift layer 101. For example, the resistivity of the FZ wafer may be approximately 25 Ωcm in the case where the diode is to have the breakdown voltage of 600 V, and approximately 55 Ωcm when the diode is to have the breakdown voltage of 1.2 kV.

### (Step for Forming Active Region)

In the first step (not shown), an oxide film is formed over a surface of the Si substrate 100 by thermal oxidation. Subsequently, a step of photolithography for forming the active region is performed, where the anode p⁻ layer 103 is to be formed in the active region. In this step, a resist having an opening corresponding to the entire active region is formed on the surface of the Si substrate 100 by applying a resist material to the surface of the Si substrate 100 and performing exposure and development. At this time, another opening corresponding to a region in which the p-type well in the termination region is to be formed is also formed in the resist. Thereafter, the portions of the oxide film which are exposed in the openings are removed by wet etching, and then the resist is also removed. By the above operations, the oxide film formed on the surface of the Si substrate 100 finally has an opening in the entire area under which the active region is to be formed and an opening in the area under which the p-type well in the termination region is to be formed.

### (Step of Forming Anode p- Layer)

After that, as illustrated in FIG. 2, an implantation-through film 109 is formed on the surface of the Si substrate 100 by thermal oxidation, and ions of p-type dopant for formation of the anode p⁻ layer 103 are implanted through the implantation-through film 109 (a thick film) by using as a mask constituted by the implantation-through film 109 and the oxide film formed in the step for formation of the active region. Thus, the p-type dopant ions for formation of the anode p⁻ layer 103 are implanted through the entire area on the active region.

### (Step of Forming Anode p Layer)

After the step of forming the anode p⁻ layer, a step of photolithography for forming the anode p layer 102 is performed as illustrated in FIG. 3. In this step, a resist 110 having openings corresponding to the regions in which the anode p layer 102 are to be formed is formed by applying a resist material to the surface of the Si substrate 100 and performing exposure and development. At this time, although not shown, another opening corresponding to the region in which the p-type well in the termination region is to be formed is also formed in the resist 110.

Subsequently, the p-type dopant ions for forming the anode p layer 102 are implanted by using the resist 110 as a mask. At the same time, p-type dopant ions are also implanted into the region in which the p-type well is to be formed in the termination region (not shown).

Thereafter, the resist 110 is removed, and then high-temperature annealing and oxidation are performed so as to diffuse the implanted p-type dopant ions, complete the formation of the anode p layer 102 and the anode p⁻ layer 103, and grow the oxide film (not shown) formed over the surface of the Si substrate 100.

### (Step of Forming Anode Electrode)

After the step of forming the anode p layer, a step of photolithography for forming a contact region is performed. In this step, a resist (not shown) having an opening corresponding to the entire active region is formed by applying a resist material and performing exposure and development.

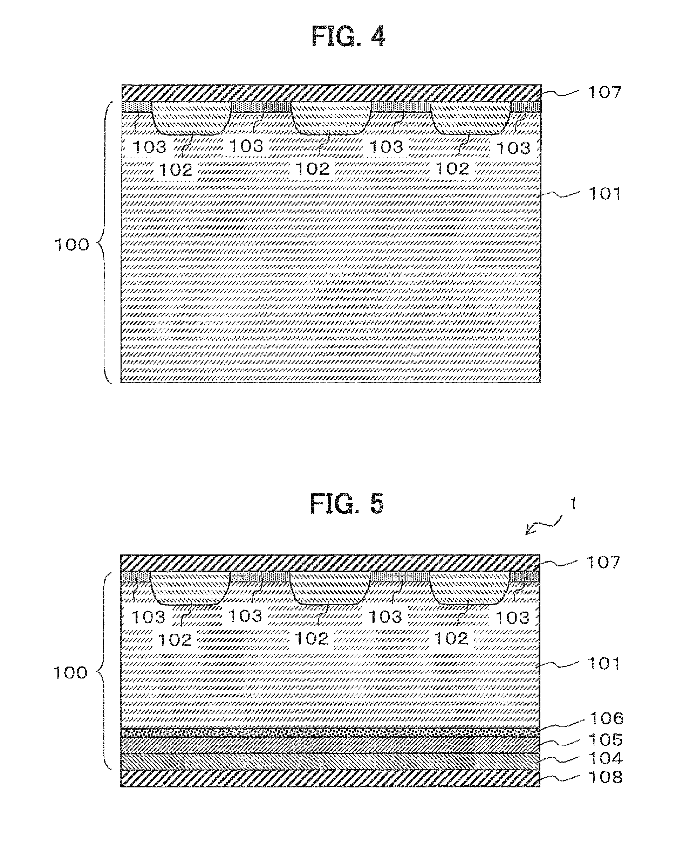

Subsequently, the portion of the oxide film (not shown) which is exposed in the opening in the above resist is removed by etching, and then the resist is removed. Thereafter, a film of a conductive material (e.g., an AlSi film) which becomes the anode electrode 107 is formed over the entire surface of the active region by sputtering or vapor deposition as illustrated in FIG. 4.

In addition, although not shown, another electrode on the p-type well in the termination region is formed by performing steps of photolithography and etching for formation of the electrode on the p-type well in the termination region. At this time, as show in Fig. 4, the AlSi film left formed on the entire surface of the active regions becomes the anode electrode 107.

Subsequently, the resist formed for the arrangement of the electrode on the p-type well in the termination region is removed, and then a protection film is formed over the termination region. For example, a protection film of polyimide can be formed over the termination region by applying a solution containing a precursor of polyimide and a photosensitive material to the surface of the termination region, and exposing the termination region to transform the precursor into polyimide.

Thus, formation of the structure on the anode side is completed.

Next, a cathode-side structure is formed as illustrated in FIG. 5.

### (Step of Grinding Back Surface)

The back surface of the Si wafer (the Si substrate 100) is ground to reduce the thickness of the wafer. The wafer thickness depends on the breakdown voltage. For example, the wafer thickness is approximately 70 micrometers for the diode having the breakdown voltage of 600 V, and approximately 120 micrometers for the diode having the breakdown voltage of 1200 V. It is preferable to perform chemical etching after mechanical grinding for eliminating the layer damaged by the grinding. For example, in the case where the diameter of the Si substrate 100 is great, for example, eight inches, in order to prevent occurrence of cracks in the wafer, it is preferable to use the grinding technique called TAIKO grinding. (TAIKO is a registered trademark.) According to the TAIKO grinding, the peripheral portion of the wafer is remained thick. In the case where the breakdown voltage of the diode is 3.3 kV or higher, the thickness of the finished Si wafer is great, so that the grinding of the back surface of the Si wafer is unnecessary.

### (Step of Forming Cathode n Layer, Cathode Buffer n Layer, and Low-lifetime Region Layer)

After the step of grinding the back surface, implantation of n-type dopant ions for formation of each of the cathode buffer n layer 105 and the cathode n layer 104 is performed in succession. At this time, the implantation of the n-type dopant ions for formation of the cathode buffer n layer 105 is performed with a higher implantation energy so as to reach a greater depth and with a lower dopant concentration than those in the implantation of the n-type dopant ions for formation of the cathode n layer 104.

Subsequently, laser annealing is performed for activating the implanted n-type dopant ions. When the activation is performed by the laser annealing, the n-type dopant on the back side can be activated without heating the electrode and the protection film (not shown) formed on the anode side of the Si substrate 100 to or above the heat resistant temperature. At this time, in the region in which the n-type dopant ions for forming the cathode buffer n layer 105 are implanted, a subregion which is located on the cathode n layer 104 side and in which activation by laser annealing is sufficiently performed becomes the cathode buffer n layer 105, and a subregion which is located on the n⁻ drift layer 101 side and in which the activation ratio is low becomes the low-lifetime region layer 106.

The laser used in the laser annealing may be, for example, the second harmonic of the YLF (yttrium lithium fluoride) laser having the wavelength of 532 nm can be used, and the YAG (yttrium aluminum garnet) laser having the wavelength of 532 nm, the YVO₄ laser having the wavelength of 532 nm, or the like can be used also. Alternatively, the lasers having shorter wavelengths, for example, the XeCl excimer laser having the wavelength of 308 nm or the KrF excimer laser having the wavelength of 248 nm may be used. The energy and the wavelength of the laser irradiation can be appropriately selected according to the depth at which the n-type dopant is activated.

Details of the ion implantation and laser annealing will be explained later.

### (Step of Forming Cathode Electrode)

After the laser annealing, the cathode electrode 108 is formed on the back surface (i.e., on the cathode side). The cathode electrode 108 can be formed by using an appropriate conductive material such as metal in a similar manner to the anode electrode 107.

Thereafter, in order to control the carrier lifetime in the entire wafer, when necessary, it is possible to perform electron-beam irradiation from the back side and annealing for recovery from damage caused by the electron-beam irradiation.

### (Step of Separation)

Finally, the wafer is separated into chips of the diode 1 by dicing or the like.

### [Conditions for Ion Implantation and Laser Annealing]

Hereinbelow, conditions for the ion implantation and the laser annealing are explained.

It is desirable that the depth at which the peak concentration of defects produced by the ion implantation be greater than the depth at which the implanted n-type dopant ions are activated by the laser annealing. In the case where the depth of the peak of the concentration of the defects produced by the ion implantation is greater than the depth of the n-type dopant ions which are implanted and activated, it is possible to reduce the variations in the amount of defects remaining in the low-lifetime region layer 106 which are caused by the variation of the distribution of both the defects produced after ion implantation and the n-type dopant ions activated by the laser annealing in the depth direction.

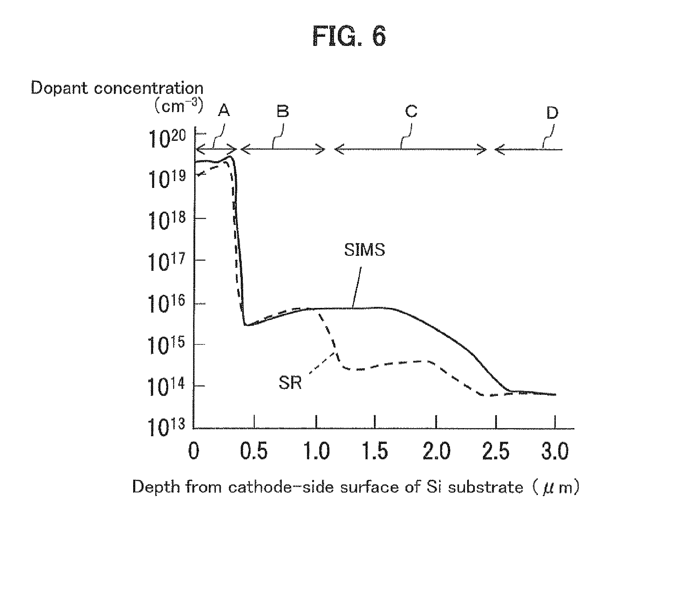

The structure, in the depth direction, of the n-type semiconductor layers on the cathode side is explained below with reference to FIG. 6 (and FIG. 1 when necessary). In FIG. 6, the solid curve indicates a concentration profile of the n-type dopants including activated and non-activated ones, and the dashed curve indicates a concentration profile of the activated n-type dopants, where both of the concentration profiles are measured along the depth direction from the back surface of the Si substrate 100 (the surface on the cathode side) of a concrete example of the diode according to the first embodiment which has been produced under the condition explained later.

The concentration profile of the n-type dopants can be obtained by measuring the concentration of the n-type dopants by SIMS (secondary ion mass spectroscopy) from the cathode-side surface of the Si substrate 100 in the diode 1, and the concentration profile of the activated n-type dopants can be obtained by measuring the distribution of the spreading resistance (SR) along the depth direction, and converting the measured SR values into carrier concentration values.

In addition, the activation ratio is defined as the ratio of the carrier concentration obtained by the SR measurement to the concentration of the n-type dopant obtained by the SIMS measurement, where the carrier concentration means the concentration of the activated n-type dopant.

The concentration profiles indicated in FIG. 6 are explained below.

In the region A from the cathode-side surface of the Si substrate 100 (at the depth zero) to the depth of approximately 0.3 micrometers, both of the concentration of the n-type dopant obtained by the SIMS measurement and the carrier concentration obtained by the SR measurement are as high as 1 X 10¹⁹ cm⁻³ or higher, and are approximately constant. In the region A, high-concentration phosphorus ions as the n-type dopant are implanted for forming the cathode n layer 104. Since the crystal of the Si substrate 100 is melted in the vicinity of the cathode-side surface, the profiles have the box-like shape in the region A. The region A corresponds to the cathode n layer 104.

In the case where the carrier concentration in the above region A is low, the electrons injected from the cathode electrode 108 when the diode 1 is conducting decrease, so that the forward voltage of the diode 1 rises. In addition, since the carrier concentration on the cathode side of the Si substrate 100 is low when the diode 1 is conducting, voltage leap or ringing is likely to occur at the time of recovery. Therefore, it is more preferable that the carrier concentration in the cathode n layer 104 be higher, and it is desirable that the carrier concentration in the cathode n layer 104 be 1 X 10¹⁹ cm⁻³ or higher.

The activation ratio of the n-type dopant in the region A (having the box-like concentration profile which indicates the cathode n layer 104) becomes 20 to 100% although the activation ratio depends on the irradiation energy of the laser. In the case where the carrier concentration is high, the activation ratio may be lower than 100%.

In the depth range around 0.3 micrometers from the cathode-side surface, the concentrations of the n-type dopant and the carrier concentration are rapidly lowered. Currently, it is impossible to measure the activation ratio in the above depth range with sufficient precision because the precision in determination of the origin in the depth direction in the SR measurement is low and the precision in the SR measurement in the vicinity of the PN junction is lowered by the influence of the depletion layer. Therefore, detailed consideration of the activation ratio in the above depth range is omitted in this specification.

In the region (including the regions B and C) in the depth range of 0.3 to 2.7 micrometers from the cathode-side surface of the Si substrate 100, the n-type dopant ions are implanted for forming the cathode buffer n layer 105. In the region B in the depth range of 0.3 to 1.0 micrometers, the carrier concentration obtained by the SR measurement is identical to the concentration of the n-type dopant obtained by the SIMS measurement, i.e., the activation ratio is approximately 100%. This is because the heat supplied by the laser irradiation to the cathode-side surface of the Si substrate 100 is sufficiently transferred to a depth of 1.0 micrometers, so that the n-type dopant in the region B is sufficiently activated in the region B. The region B corresponds to the cathode buffer n layer 105, which is electrically effective.

In the region C deeper than 1.0 micrometers (in the region in the depth range of 0.3 to 2.7 micrometers in which the n-type dopant ions are implanted for forming the cathode buffer n layer 105), the carrier concentration obtained by the SR measurement is lower than the concentration of the n-type dopants obtained by the SIMS measurement, i.e., the activation ratio of the n-type dopants is lowered in the region C. This is because the heat supplied by the laser irradiation is not sufficiently transferred to the region C, so that defects produced by the ion implantation remain in the region C. Therefore, the activation ratio in the region C is low, and the region C includes a region in which the activation ratio is lower than 1%. Since the defects remain in the region C, the carrier lifetime is short in the region C. The region C corresponds to the low-lifetime region layer 106.

In addition, in the region D in the depth range of 2.7 micrometers and greater, the n-type dopant ions are not implanted. The region D corresponds to the n⁻ drift layer 101.

The low-lifetime region layer 106 will be defined on the basis of the profiles indicated in FIG. 6. The low-lifetime region layer 106 is defined as a region which is located between the cathode buffer n layer 105 and the n⁻ drift layer 101 and in which the activation ratio in vicinities of a boundary with the cathode buffer n layer 105 and a boundary with the n⁻ drift layer 101 are 10% or lower. As explained later, when the activation ratio is 10% or lower, the effect of reducing the recovery loss can be achieved.

In the example indicated in FIG. 6, the depth at which the concentration of the n-type dopant ions implanted for formation of the cathode buffer n layer 105 peaks is approximately 1.2 micrometers. In addition, for example, in the case where phosphorus ions as the n-type dopant ions are implanted with the energy of 720 keV, the depth of the peak of the amount of defects is approximately 10% smaller than the depth of the peak of the n-type dopant. Therefore, the depth of the peak of the amount of defects is approximately 1.1 micrometers.

The depth of the peak of the amount of defects can be obtained by a calculation or a process simulation which use, for example, the energy needed for displacement of a Si atom. In addition, the defects in the above consideration is the defects which are produced by the ion implantation and cause recombination centers.

On the other hand, the depth at which the concentration of the activated n-type dopant peaks when the implanted n-type dopant ions are sufficiently activated by the laser annealing is approximately 1.0 micrometers as indicated in FIG. 6. That is, the depth (1.1 micrometers) of the peak of the amount of defects which is obtained by the process simulation is greater than the depth of the peak of the concentration of the sufficiently activated n-type dopant ions.

In order to make the depth of the peak of the amount of defects greater than the depth of the peak of the concentration of the n-type dopant activated by the laser annealing, the depth of the distribution of the defects is increased, or the depth at which the n-type dopant is activated by the laser annealing is decreased.

In order to increase the depth of the distribution of the defects, a lighter element is used as the n-type dopant, or the ion implantation energy is increased. If hydrogen (proton) or helium is used as the n-type dopant, the projected range of the injected ions is too large, so that the spread of the implanted ions in the depth direction becomes too large. In addition, a large particle-beam irradiation system using a cyclotron is needed. Therefore, it is most desirable to use phosphorus, which is the lightest one of the n-type dopant elements used for formation of n-type doped layers in manufacturing of LSIs (large-scale integrated circuits).

Higher ion implantation energy enables deeper implantation of the n-type dopant. However, it is preferable that the ion implantation energy be high within the maximum possible range of the particle-beam irradiation system and within the range in which the controllability needed for generation of the defect layer can be obtained.

In order to decrease the depth at which the n-type dopant is activated by the laser annealing, the energy transferred to the Si substrate 100 by the laser irradiation is reduced, or the wavelength of the laser is shortened.

For example, although the laser irradiation energy is 1.5 J/cm² in the example of FIG. 6, the depth at which the n-type dopant is activated can be further decreased by decreasing the laser irradiation energy. In addition, the depth at which the n-type dopant is activated can be also decreased by shortening the irradiation time of the laser or reducing the number of irradiating operations.

Although the second harmonic of the YLF laser having the wavelength of 532 nm is used in the example of FIG. 6, the depth at which the n-type dopant is activated can be further decreased by using the XeCl excimer laser having the wavelength of 308 nm or the KrF excimer laser having the wavelength of 248 nm.

### <Second Embodiment>

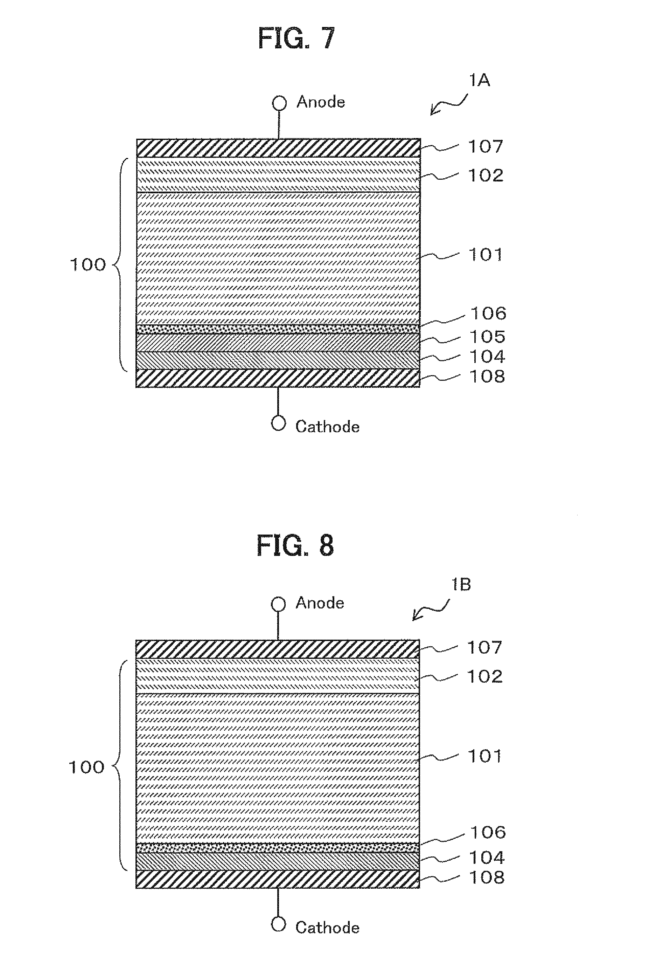

Next, the structure of the diode according to the second embodiment according to the present invention is explained below with reference to FIG. 7. FIG. 7 is a schematic cross-sectional view of the active region of the diode 1A according to the second embodiment. Although the termination region is not shown, similarly to the first embodiment, a conventional termination structure such as an FLR (field limiting ring) structure is used in the termination region. In the FLR structure, a p-type well and an electrode are arranged in a circular arrangement.

As illustrated in FIG. 7, the diode 1A according to the second embodiment is different from the diode 1 according to the first embodiment (illustrated in FIG. 1) in that the anode p layer 102 (corresponding to the aforementioned second semiconductor layer) does not have a well structure and is formed over the entire anode-side surface of the active region without arranging the anode p⁻ layer 103. The structure of the other portions of the diode 1A is similar to the diode 1, and therefore no explanation on the other portions of the diode 1A is presented here.

Since the anode p layer 102 is formed over the entire surface, on the anode electrode 107 side, of the active region in the diode 1A according to the present embodiment, the step of photolithography for locally forming the anode p layer 102 can be omitted, so that the manufacturing cost can be reduced. The other steps for manufacturing the diode 1A according to the present embodiment are similar to the corresponding steps in the first embodiment, and therefore no explanation on the other steps for manufacturing the diode 1A is presented here.

### 3. Third Embodiment

Next, the structure of the diode according to the third embodiment according to the present invention is explained below with reference to FIG. 8. FIG. 8 is a schematic cross-sectional view of the active region of the diode 1B according to the third embodiment. Although the termination region is not shown, similarly to the first and second embodiments, a conventional termination structure such as an FLR (field limiting ring) structure is used in the termination region. In the FLR structure, a p-type well and an electrode are arranged in a circular arrangement.

As illustrated in FIG. 8, the diode 1B according to the third embodiment is different from the diode 1A according to the second embodiment (illustrated in FIG. 7) in that the cathode buffer n layer 105 is not arranged, and the low-lifetime region layer 106 (the fourth semiconductor layer) is arranged in a position adjoining to the n⁻ drift layer 101 side (the first semiconductor layer side) of the cathode n layer 104 (the third semiconductor layer). In addition, the n-type dopant (element) contained in the low-lifetime region layer 106 is a same type of the n-type dopant contained in the cathode n layer 104, and the activation ratio of the n-type dopant in the low-lifetime region layer 106 is controlled to be so low that the carrier lifetime in the low-lifetime region layer 106 is shorter than the carrier lifetime in the cathode n layer 104.

Further, the preferable depth and thickness of the low-lifetime region layer 106 in the third embodiment are similar to the first embodiment. The structure of the other portions of the diode 1B according to the present embodiment is similar to the first embodiment, and therefore no explanation on the other portions of the diode 1B is presented here.

Since the diode 1B according to the present embodiment does not contain the cathode buffer n layer 105, it is unnecessary to perform the ion implantation of the n-type dopant for forming the cathode buffer n layer 105. In the diode 1B, an n-type doped layer which is electrically effective is formed in a position deeper than a high-concentration n-type doped layer having the box-like concentration profile (corresponding to the region A indicated in FIG. 6) by using the n-type dopant ions implanted for formation of the cathode n layer 104, instead of the n-type dopant ions which are implanted for formation of the cathode buffer n layer 105 in the process for manufacturing the diode 1 according to the first embodiment (and the process for manufacturing the diode 1A according to the second embodiment). In this case, the number of ion-implantation operation(s) can be reduced to only one. In addition, in this case, the ion implantation energy of the n-type dopant for formation of the cathode n layer 104 is increased in order to produce the layer containing the defects in the deeper position, or the laser irradiation energy is decreased in order to decrease the depth at which the laser annealing causes recovery of the layer containing the defects. When the ion implantation energy is increased or the laser irradiation energy is decreased as above, a low-concentration region having a concentration profile similar to the region C indicated in FIG. 6 can be formed as the low-lifetime region layer 106 in a position abutting the cathode n layer 104. The other steps for manufacturing the diode 1B according to the present embodiment are similar to the corresponding steps in the first and second embodiments, and therefore no explanation on the other steps for manufacturing the diode 1B is presented here.

Alternatively, the p-type semiconductor layers in the diode 1B according to the third embodiment may be arranged to form a well structure with the anode p layer 102 and the anode p⁻ layer 103. Further alternatively, a well structure may be formed with only the anode p layer 102 without the anode p⁻ layer 103.

### 4. Fourth Embodiment

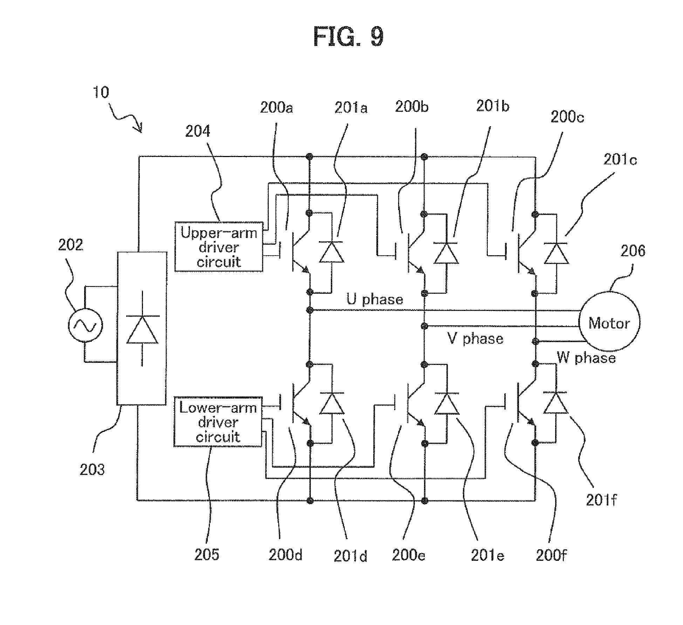

Next, a power conversion system according to the fourth embodiment of the present invention is explained with reference to FIG. 9. The power conversion system 10 according to the fourth embodiment illustrated in FIG. 9 uses the diode according to the present invention.

As illustrated in FIG. 9, the power conversion system 10 according to the fourth embodiment contains a 3-phase inverter for driving a motor. In the power conversion system 10, diodes 201a to 201f are respectively connected in reverse parallel with IGBTs (insulated gate bipolar transistors) 200a to 200f as semiconductor switching elements. That is, the diodes 201a to 201f function as free wheeling diodes, and are each the diode according to one of the first to third embodiments or a variation of the diode according to one of the first to third embodiments. Each of the IGBTs 200a to 200c (the first semiconductor switching elements) is combined with and connected in series to one of the IGBTs 200d to 200f (the second semiconductor switching elements), so that a pair of reverse-parallel circuits each formed with one of the IGBTs and one of the diodes are connected in series and constitute a half-bridge circuit corresponding to one of the three phases.

The number of the half-bridge circuits corresponds to the number of phases in the alternating current. Therefore, in the present embodiment, three half-bridge circuits corresponding to the three phases are arranged in the power conversion system 10. A U-phase AC (alternating current) output is obtained from the series connection point between the pair of IGBTs 200a and 200d, a V-phase AC output is obtained from the series connection point between the pair of IGBTs 200b and 200e, and a W-phase AC output is obtained from the series connection point between the pair of IGBTs 200c and 200f. The U-phase, V-phase, and W-phase AC outputs are to be connected to a motor 206, which is, for example, an induction type or a synchronous type.

The collectors of the IGBTs 200a to 200c on the upper-arm side are connected in common to the high-voltage side of a rectifier circuit 203, and the emitters of the IGBTs 200d to 200f on the lower-arm side are connected in common to the earth side of the rectifier circuit 203. The rectifier circuit 203 converts the AC output of an AC power supply 202 into DC output. The DC output of the rectifier circuit 203 is converted into the AC outputs by switching on/off the IGBTs 200a to 200f for driving the motor 206. The driver circuits 204 and 205 for the upper arm and the lower arm perform on/off control of the IGBTs 200a to 200f by supplying drive signals from the upper-arm driver circuit 204 to the gates of the IGBTs 200a to 200c on the upper-arm side, and from the lower-arm driving circuit 205 to the gates of the IGBTs 200d to 200f on the lower-arm side.

Since the diodes 201a to 201f according to the present invention are respectively connected as free wheeling diodes in reverse parallel with the IGBTs 200a to 200f, the recovery loss at the time of switching can be reduced. Therefore, the energy efficiency in the entire power conversion system 10 can be improved.

The present invention is not limited to the explained embodiments, and various embodiments can be practiced within the scope of the present invention. For example, the present invention can be applied to a diode built in a reverse-conducting semiconductor switching element. Further, in the power conversion system 10 illustrated in FIG. 9, the IGBTs 200a to 200f may be replaced with other semiconductor switching elements such as MOSFETs (metal oxide semiconductor field effect transistors), bipolar junction transistors, junction FETs, static induction transistors, or GTO (gate turn-off) thyristors.

### EXAMPLES

Hereinbelow, the aforementioned concrete example of the diode 1 which has been produced according to the first embodiment of the present invention illustrated in FIG. 1 is explained with reference to FIG. 1 and other diagrams indicating results of analysis when necessary.

### (Production Condition)

In the diode as the concrete example of the present invention, an n-type Si wafer is used as the Si substrate 100. Phosphorus is used as the n-type dopant for formation of the cathode buffer n layer 105, the energy is 720 keV, the off-angle is 0 degrees, and the dose is 1 X 10¹² cm⁻². In addition, phosphorus is used as the n-type dopant for formation of the cathode n layer 104, the energy is 60 keV, the off-angle is 7 degrees, and the dose is 1 X 10¹⁵ cm⁻². Thereafter, irradiation with the second harmonic of the YLF laser having the wavelength of 532 nm is performed with the irradiation energy of 1.5 J/cm² for laser annealing and activation of the implanted n-type dopant.

In addition, a diode as a comparison example 1 has been produced. The diode as the comparison example 1 is different from the concrete example of the present invention in that the laser annealing is performed with higher laser irradiation energy of 2.0 J/cm² in production of the comparison example 1. The other conditions for production of the comparison example 1 including the ion implantation condition are identical to the conditions for production of the concrete example. Therefore, the diode as the comparison example 1 is a diode with a structure containing the cathode buffer n layer 105 and not containing the low-lifetime region layer 106.

A further diode as a comparison example 2 has been produced. The diode as the comparison example 2 is different from the concrete example of the present invention in that the ion implantation of the n-type dopant for formation of the cathode buffer n layer 105 is not performed in production of the comparison example 2. Therefore, the diode as the comparison example 2 is a diode with a structure containing neither of the cathode buffer n layer 105 and the low-lifetime region layer 106.

### (Result of Analysis)

As explained in detail before, the results of the analysis of the structure on the cathode side of the diode as the concrete example are indicated in FIG. 6, and the explanations on the results are not repeated here.

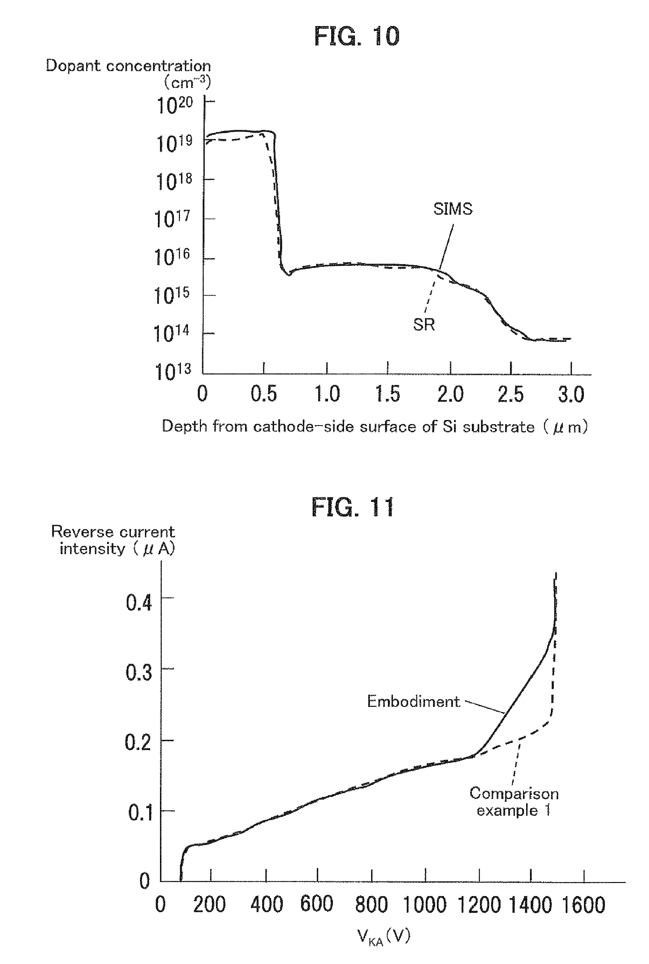

FIG. 10 indicates a concentration profile of the n-type dopant obtained by SIMS measurement (indicated by the solid curve) and a concentration profile of the carriers obtained by SR measurement (indicated by the dashed curve) in the diode as the comparison example 1.

As illustrated in FIG. 10, the concentration profile of the n-type dopant obtained by SIMS measurement and the concentration profile of the carriers obtained by SR measurement are approximately identical in the depth range from 0 micrometers (from the cathode-side surface) to 3 micrometers. When the laser irradiation energy in the laser annealing is increased, the heat generated by the laser irradiation is sufficiently transferred to the depth of 3 micrometers, and approximately 100% of the n-type dopant is activated in the entire region in which the n-type dopant is implanted for formation of the cathode buffer n layer, so that the low-lifetime region layer 106 is not formed.

In other words, the low-lifetime region layer 106, in which the defects produced by the ion implantation remain, can be formed in the position adjoining to the cathode buffer n layer 105 as indicated in FIGS. 1 and 6 by controlling the conditions on the ion implantation and the laser irradiation without adding the other steps in the manufacturing process from the manufacturing process of the conventional diode.

### (Reverse Characteristics)

FIG. 11 indicates a reverse characteristic of the diode as the concrete example of the present invention (by the solid curve) and a reverse characteristic of the diode as the comparison example 1 (by the dashed curve).

As indicated in FIG. 11, in the reverse characteristic of the diode as the comparison example 1, the gradient of the reverse current curve does not substantially change (i.e., the leakage current monotonously increases) under the breakdown voltage of 1500 V.

On the other hand, as indicated in FIG. 11, in the reverse characteristic of the diode as the concrete example, there is a point at which the gradient of the reverse current curve substantially changes, at approximately 1200 V (which is lower than the breakdown voltage of 1500 V), and the gradient of the reverse current curve is great in the range of the reverse voltage equal to or higher than 1200 V. When the reverse voltage is applied to the diode as the concrete example, the depletion layer extends from the PN junction located on the anode side. Further, when the reverse voltage reaches 1200 V, the depletion layer reaches the low-lifetime region layer 106 (in which the defects remain), and an electric field is applied to the low-lifetime region layer 106, so that leakage current due to the defects is increased. Therefore, the reverse characteristic of the diode as the concrete example includes the point at which the gradient of the reverse current curve substantially changes, and the leakage current remarkably increases above the point. This reverse characteristic indicates that the low-lifetime region layer 106 contains defects.

In the diode as the concrete example of the present invention, as indicated as the region C in FIG. 6, the low-lifetime region layer 106 is formed at depth as small as 1.2 to 2.4 micrometers from the cathode-side surface of the Si substrate 100 (i.e., from the interface between the cathode n layer 104 and the cathode electrode 108). That is, in the concrete example, the depth of the low-lifetime region layer 106 is at most 2.4 micrometers (i.e., the depth of the interface between the low-lifetime region layer 106 and the n⁻ drift layer 101 is 2.4 micrometers from the cathode-side surface of the Si substrate 100). When the ion implantation energy in the ion implantation into the n⁻ drift layer 101 is increased, the depth of the low-lifetime region layer 106 increases. However, the depth of the low-lifetime region layer 106 is at most approximately 5 micrometers even when phosphorus ions are implanted with the ion implantation energy of 3 MeV, which is the upper limit energy of the typical ion implant apparatus used in semiconductor manufacturing.

Generally, in the free wheeling diode, in order to suppress the voltage leap or ringing at the time of recovery, the thickness of the Si substrate is designed such that the depletion layer which extends when reverse voltage is applied does not reach the region to the depth of at least 10 micrometers from the cathode-side surface. Therefore, the diode according to the present invention is formed such that the depletion layer does not reach the low-lifetime region layer 106, and it is possible to prevent increase in the leakage current. Specifically, since the low-lifetime region layer 106 is formed by the ion implantation performed for formation of the cathode buffer n layer 105, the depth of the low-lifetime region layer 106 becomes at most 5 micrometers. Therefore, it is possible to prevent increase in the leakage current when reverse voltage is applied by forming the cathode n layer 104, the cathode buffer n layer 105, and the low-lifetime region layer 106 such that each of the cathode n layer 104, the cathode buffer n layer 105, and the low-lifetime region layer 106 satisfactorily functions.

On the other hand, if the low-lifetime region layer 106 is formed by irradiation with protons or helium ions, because of the light mass of the injected particles, the thickness of the low-lifetime region layer 106 becomes as much as approximately 10 to 70 micrometers although the thickness of the low-lifetime region layer 106 varies with the irradiation energy. Therefore, the deepest position of the low-lifetime region layer 106 from the cathode-side surface of the Si substrate 100 becomes deeper. In this case, the voltage at which the leakage current begins to increase becomes low, compared with the case where the low-lifetime region layer 106 is formed at a smaller depth. Therefore, in the above case, the voltage applied to the low-lifetime region layer 106 increases, and the leakage current becomes unignorable.

Further, if the low-lifetime region layer 106 is formed by irradiation with protons or helium ions, because of the light mass of the injected particles, the projected range of the injected ions becomes large, and the distribution range of the implanted ions in the depth direction is increased. Therefore, it is difficult to satisfactorily control the thickness of the low-lifetime region layer 106 and the amount of defects contained in the low-lifetime region layer 106.

In the case where implantation of phosphorus ions, which are the same as the n-type dopant ions used for formation of the n-type cathode-side layers (i.e., the cathode n layer 104 and the cathode buffer n layer 105), is used as in the concrete example of the present invention, it is possible to form the low-lifetime region layer 106 while satisfactorily controlling the thickness and the amount of defects. Alternatively, arsenic (As) or antimony (Sb), which is heavier than phosphorus, may be used instead of phosphorus. In the case where an element heavier than phosphorus, such as As or Sb, is used for formation of the low-lifetime region layer 106, ion implantation with higher energy enables formation of the low-lifetime region layer 106 at a depth to which the heat generated by the laser irradiation is not substantially transferred.

### (Waveforms of Current and Voltage at the Time of Recovery)

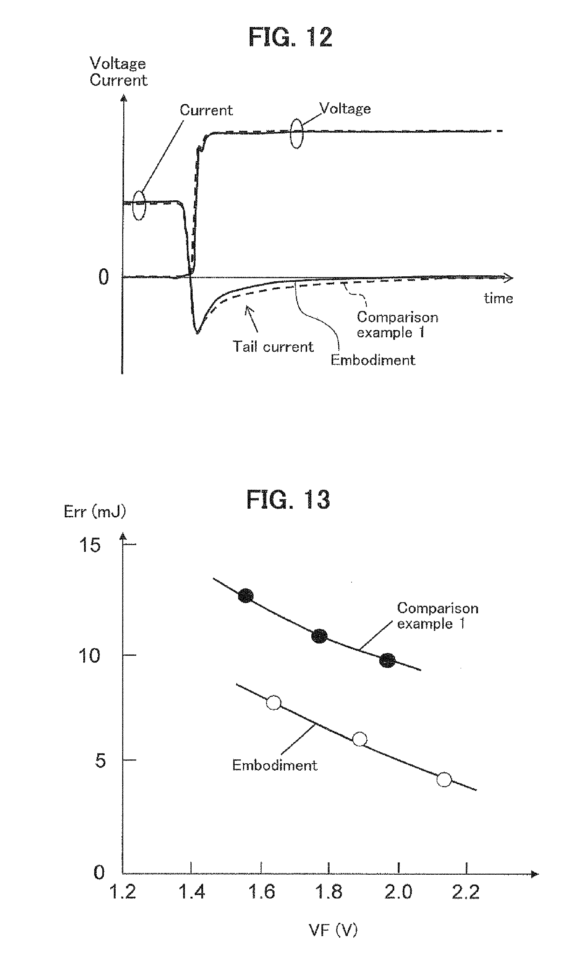

FIG. 12 indicates waveforms of the current and the voltage in the recovery characteristics of the diodes as the concrete example of the present invention and the comparison example 1 at the temperature of 150°C. The waveforms of the voltage in the concrete example and the comparison example 1 are approximately identical. On the other hand, in the waveform of the current, the tail current in the concrete example is smaller (nearer to zero) than the tail current in the comparison example 1. (In FIG. 12, the tail currents in the concrete example and the comparison example 1 are indicated by the arrow.) This is because the carriers remaining in the n⁻ drift layer 101 at the time of recovery are quickly annihilated due to the existence of the low-lifetime region layer 106, which has the shorter carrier lifetime than the n⁻ drift layer 101.

Because of the reduction in the tail current, the recovery loss in the diode as the concrete example is as small as 6 mJ, while the recovery loss in the diode as the concrete example is 11 mJ. That is, in the concrete example, the recovery loss is reduced to approximately half. Since the amount of reduction in the recovery loss of the diode depends on the specification requirements and evaluation conditions of the diode, the effect of reducing the recovery loss varies with the individual diode. However, especially when the tail current is great, the effect of reducing the recovery loss is great. Therefore, the present invention is highly usable.

### (Recovery Loss)

FIG. 13 is a graph indicating a trade-off relationship between the forward voltage VF and the recovery loss Err in each of the diodes as the concrete example of the present invention and the comparison example 1. Both of the forward voltage VF and the recovery loss Err have been measured at the temperature of 150°C. (In FIG. 13, the blank circles indicate data in the concrete example and the filled circles indicate_data in the comparison example 1.) The three measured points in the measurement for each of the concrete example of the present invention and the comparison example 1 correspond to different doses in the electron irradiation for controlling the carrier lifetime to be uniform in the depth direction in the Si substrate 100.

When the electron irradiation dose is increased, the forward voltage VF increases and the recovery loss Err decreases as indicated in FIG. 13. In the diode as the concrete example, although the forward voltage VF is slightly increased by the introduction of the layer containing the defects, the recovery loss Err is more reduced than in the comparison example 1 by the effect of reducing the tail current as explained above, so that the trade-off relationship between the forward voltage VF and the recovery loss Err is improved.

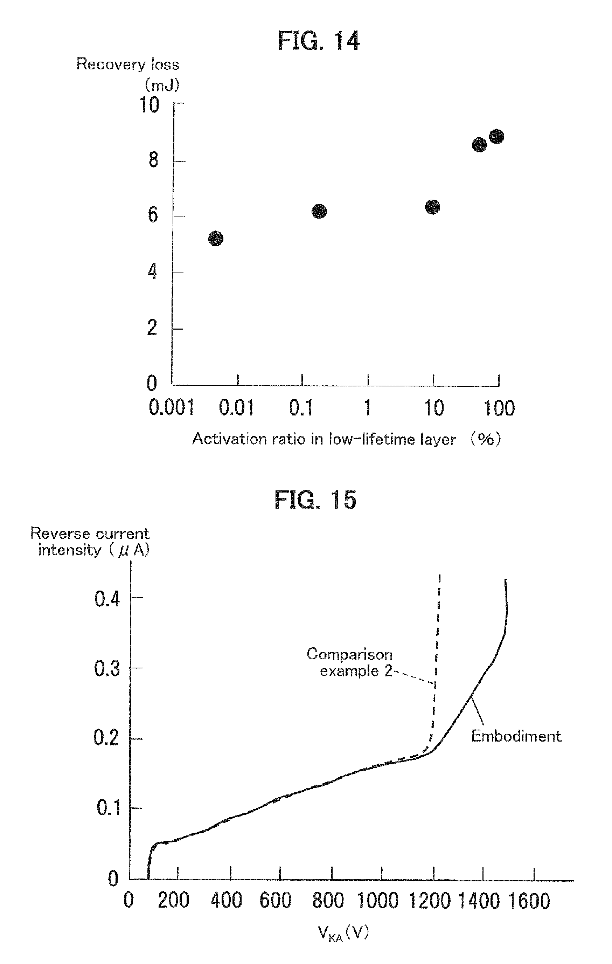

FIG. 14 indicates the relationship between the recovery loss and the activation ratio of the n-type dopant in the low-lifetime region layer 106. The activation ratio in the low-lifetime region layer 106 is reduced by increasing the dose of the n-type dopant ions implanted for formation of the cathode buffer n layer 105, or decreasing the laser irradiation energy performed for activation of the n-type dopants after the ion implantation. As understood from FIG. 14, it is preferable that the low-lifetime region layer 106 contains a region in which the activation ratio is 10% or lower. The activation ratio of 10% or lower in the low-lifetime region layer 106 makes it possible to quickly annihilate the carriers remaining in the n⁻ drift layer 101 at the time of recovery and reduce the tail current.

### (Effect of Cathode Buffer n Layer)

FIG. 15 indicates a reverse characteristic of the diode as the comparison example 2 (by the dashed curve) together with the reverse characteristic of the diode as the concrete example of the present invention (by the solid curve). The reverse characteristic of the diode as the concrete example indicated in FIG. 15 is the same as the reverse characteristic of the diode as the concrete example indicated in FIG. 11.

Since the diode as the concrete example contains the cathode buffer n layer 105, which is electrically effective, extension of the depletion layer which occurs when reverse voltage is applied is suppressed, so that the breakdown voltage is improved to 1500 V from the value of 1200 V in the comparison example 2 as indicated in FIG. 15.

Like the diode as the comparison example 1, the diode 1B according to the third embodiment of the present invention (illustrated in FIG. 8) does not contain the cathode buffer n layer 105, so that the breakdown voltage in the diode 1B according to the third embodiment is lowered. However, the process for manufacturing the diode 1B is simplified as explained before. Further, the low-lifetime region layer 106 is arranged in the position adjoining to the cathode n layer 104 in the diode 1B according to the third embodiment, while neither of the cathode buffer n layer 105 and the low-lifetime region layer 106 (adjoining to the cathode buffer n layer 105) is arranged in the comparison example 2. Therefore, in the reverse characteristic of the diode 1B according to the third embodiment, the gradient of the reverse current curve substantially changes at a voltage lower the breakdown voltage. The breakdown voltage is the voltage at which the diode 1B comes to the punch-through state, and corresponds to a voltage around 1200 V in the reverse characteristic curve of the comparison example 2 indicated in FIG. 15. That is, the relationship between the reverse current characteristic of the diode 1B according to the third embodiment and the reverse current characteristic of the diode as the comparison example 2 is similar to the relationship between the reverse current characteristic of the diode as the concrete example and the reverse current characteristic of the diode as the comparison example 1 which is explained with reference to FIG. 1. Therefore, the tail current and the recovery loss in the diode 1B according to the third embodiment are reduced compared with the comparison example 2.

The above embodiments of the invention as well as the appended claims and figures show multiple characterizing features of the invention in specific combinations. The skilled person will easily be able to consider further combinations or sub-combinations of these features in order to adapt the invention as defined in the claims to his specific needs.

## Claims

1. A diode comprising:
a first semiconductor layer (101) of a first conductive type;
a second semiconductor layer (102) of a second conductive type which is arranged adjoining to the first semiconductor layer (101);
a third semiconductor layer (104) of the first conductive type which is arranged on a side, opposite to the second semiconductor layer (102), of the first semiconductor layer (101), and contains a dopant of the first conductive type at a concentration higher than the first semiconductor layer (101);
a first electrode (107) ohmically connected to the second semiconductor layer (102);
a second electrode (108) ohmically connected to the third semiconductor layer (104); and
a fourth semiconductor layer (106) which is arranged at a position adjoining to the third semiconductor layer (104) between the first semiconductor layer (101) and the third semiconductor layer (104), contains a dopant of which type is the same as a type of the dopant of the first conductive type contained in the third semiconductor layer (104), and has a carrier lifetime shorter than the third semiconductor layer (104).

2. The diode according to claim 1, wherein the third semiconductor layer (104) contains a fifth semiconductor layer (105) of the first conductive type in a region adjoining to the fourth semiconductor layer (106), the concentration of the dopant of the first conductive type in the fifth semiconductor layer (105) is relatively lower than the concentration of the dopant of the first conductive type in other regions of the third semiconductor layer (104), and the fifth semiconductor layer (105) has a carrier lifetime longer than the carrier lifetime of the fourth semiconductor layer (106).

3. The diode according to claim 1, wherein an activation ratio is defined in each of the third semiconductor layer (104) and the fourth semiconductor layer (106) as a ratio of a carrier concentration obtained by measurement of a spreading resistance to a concentration of the dopant of the first conductive type which is obtained by secondary ion mass spectroscopy, and the activation ratio in the fourth semiconductor layer (106) is smaller than the activation ratio in the third semiconductor layer (104).

4. The diode according to claim 2, wherein the fourth semiconductor layer (104) contains defects.

5. The diode according to claim 4, wherein the defects are caused by implantation of ions of the dopant of the first conductive type which is performed for formation of the third semiconductor layer (104).

6. The diode according to claim 3, wherein the third semiconductor layer (104) and the fourth semiconductor layer (106) are formed by implantation of ions of the dopant of the first conductive type performed for formation of the third semiconductor layer (104) and laser irradiation performed after the implantation.

7. The diode according to claim 3, wherein the fourth semiconductor layer (106) contains a region in which the activation ratio is 10% or lower.

8. The diode according to claim 3, wherein an interface between the second electrode (108) and the third semiconductor layer (104) is apart from an interface between the fourth semiconductor layer (106) and the first semiconductor layer (101) by a distance of 5 micrometers or smaller.

9. The diode according to claim 3, wherein a position at which defects caused by implantation of ions of the dopant of the first conductive type performed for formation of the third semiconductor layer (104) are most highly concentrated is located in the fourth semiconductor layer (106).

10. The diode according to claim 3, wherein the dopant of the first conductive type contained in the third semiconductor layer (104) is phosphorus.

11. The diode according to claim 3, wherein a gradient of a characteristic curve of a reverse current versus a reverse voltage when the reverse voltage is higher than a predetermined reverse voltage which is lower than a breakdown voltage is greater than a gradient of the characteristic curve when the reverse voltage is lower than the predetermined reverse voltage.

12. A power conversion system comprising:
a first switching element (200a-200c) and a second switching element (200d-200f) which are connected in series; and
a diode (201a-201f) which is connected to each of the first switching element (200a-200c) and the second switching element (200d-200f) in a reverse parallel connection;
wherein the diode (201a-201f) connected to each of the first switching element (200a-200c) and the second switching element (200d-200f) is the diode according to any one of claims 1 to 11.
